# FASCICULE DE BREVET EUROPEEN

(11) **EP 0 969 266 B1**
(45) Date de publication et mention de la délivrance du brevet: **10.12.2003**
(21) Numéro de dépôt: 98112139.5
(22) Date de dépôt: 01.07.1998
(51) Int. Cl.: G01B 7/30, H03K 17/97, H03K 17/975, G04C 3/14

(54) **Dispositif et procédé pour la détection des positions angulaires d'au moins deux roues coaxiales à l'aide d'un seul capteur**
Vorrichtung und Verfahren zur Bestimmung der Winkellage von mindestens zwei koaxialen Rädern mit einem einzigen Sensor
Device and Method for Detecting the Angular Positions of at least two Coaxially Arranged Wheels by a Single Detector

(43) Date de publication de la demande: 05.01.2000
(73) Titulaire: ASULAB S.A., CH-2501 Bienne (CH)
(72) Inventeur: Farine, Pierre-André, 2003 Neuchâtel (CH); Born, Jean-Jacques, 1110 Morges (CH); Bernasconi, Ermanno, 2000 Neuchâtel (CH)
(74) Mandataire: Thérond, Gérard Raymond

(56) Documents cités:
- WO-A-97/45705
- DE-A- 3 828 810
- DE-C- 19 524 030
- US-A- 4 238 781

## Description

La présente invention concerne d'une part un dispositif de petites dimensions comprenant au moins deux roues coaxiales, montées rotatives autour d'un même axe géométrique de rotation et des moyens de détection des positions angulaires de demi-axes géométriques de référence associés à ces roues. D'autre part, la présente invention concerne un procédé de détection des positions angulaires de plusieurs roues coaxiales applicable au dispositif selon l'invention.

L'homme du métier connaît des dispositifs optiques de détection de positions angulaires de référence de roues, notamment de roues coaxiales appartenant au rouage d'un mouvement horloger (voir e.g., DE-A-3828810 ou DE-C-19524030). Tous ces dispositifs optiques de détection sont relativement complexes. Ils nécessitent une source lumineuse et un récepteur de lumière distant de cette source. Le montage d'un dispositif de détection optique est souvent délicat étant donné l'ajustement précis nécessaire entre la source lumineuse, le récepteur et les roues associées à ce dispositif. Dans le cas de la présente invention, il est donc prévu de s'affranchir de tout système optique de détection de la position de roue d'un dispositif de petites dimensions.

Il est connu de la demande internationale WO 97/45705 un système de détection de la position de roues coaxiales respectivement associées à des aiguilles coaxiales d'un mouvement horloger. Sur chacune des roues coaxiales, formées de plateaux pleins, sont agencées plusieurs parties discrètes d'un film dur magnétique définissant un motif d'identification pour un capteur magnétique sans contact. A chacune des roues coaxiales est associé un capteur magnétique respectif. En d'autres termes, il est prévu autant de capteurs magnétiques que de roues coaxiales dont il est prévu de détecter des positions angulaires, en particulier des positions de référence données. L'amplitude du signal détecté par ces capteurs magnétiques varie selon qu'ils sont situés devant un segment de matériau magnétique ou non, comme cela ressort notamment des figures 3 et 4 de cette demande de brevet internationale.

Le système de détection proposé dans ce document WO 97/45705 est désavantageux par le fait que chaque roue associée à un capteur magnétique doit être munie du segment ou partie distincte d'un film solide en matériau magnétique agencé sur une face du plateau de la roue. Le coût de fabrication des roues est donc augmenté et les plateaux des roues sont pleins, ce qui peut être un inconvénient pour la marche du mouvement horloger, notamment d'un point de vue énergétique. Les plateaux des roues sont formés d'au moins deux matériaux différents à savoir le matériau formant le plateau lui-même et le matériau magnétique agencé à une surface de ce plateau. Outre ces inconvénients, on mentionnera un inconvénient majeur relatif au coût du système de détection proposé et relatif à l'encombrement de ce système; à savoir qu'il est prévu autant de capteurs magnétiques que de roues dont il est prévu de détecter la position. Ainsi, pour trois roues coaxiales, il est prévu trois capteurs magnétiques associés respectivement à ces trois roues.

Un but de la présente invention est de palier les inconvénients susmentionnés en fournissant un dispositif de petites dimensions comprenant des roues coaxiales et des moyens de détection efficaces de la position angulaire d'au moins deux roues coaxiales qui sont relativement peu complexes, peu onéreux, peu encombrants et facilement intégrables dans le dispositif.

A cet effet, la présente invention concerne un dispositif de petites dimensions, notamment du type horloger, comprenant une première roue et une deuxième roue coaxiales, montées rotatives autour d'un même axe géométrique de rotation et comportant respectivement un premier plateau et un deuxième plateau perpendiculaires audit axe géométrique de rotation, ce dispositif comprenant en outre des moyens de détection des positions angulaires d'un premier demi-axe géométrique de référence de ladite première roue et d'un deuxième demi-axe géométrique de référence de ladite deuxième roue, ce dispositif étant caractérisé en ce que lesdits moyens de détection des positions angulaires desdits premier et deuxième demi-axes sont constitués par un seul et même capteur inductif ou capacitif pourvu d'un organe de détection de la présence de matériaux actifs au-dessus ou au-dessous de celui-ci, ledit premier plateau comprenant au moins une région inactive pour ledit capteur, lesdits premier et deuxième plateaux étant formés au moins partiellement de matériaux actifs pour ledit capteur, ce capteur étant agencé relativement à ladite première roue de manière que son organe de détection soit au moins en partie au-dessus ou au-dessous de ladite première région inactive dans au moins une position angulaire déterminée de cette première roue.

Grâce aux caractéristiques du dispositif selon l'invention les positions angulaires respectives d'au moins deux roues coaxiales sont déterminées à l'aide d'un seul et même capteur inductif ou capacitif, en particulier à l'aide d'un capteur inductif dont le circuit électronique est décrit dans le document EP 0 746 100, lequel est intégré par référence à la présente description.

L'utilisation d'un capteur inductif de proximité est particulièrement bien approprié dans le cas de la présente invention, un tel capteur pouvant détecter la présence de divers matériaux, en particulier de métaux non ferromagnétique comme l'aluminium ou le laiton largement utilisé pour la fabrication de roues et autres parties d'un mouvement horloger.

Selon un mode de réalisation préféré, ladite première région inactive du plateau de la première roue est définie par une première ouverture prévue dans ce plateau. Plus généralement, il est prévu que toutes les régions inactives des plateaux des roues coaxiales associées au capteur sont définies par des ouvertures. De ce fait, les plateaux des roues coaxiales peuvent être formés d'un seul et même matériau actif pour le capteur choisi, les ouvertures prévues dans ces plateaux correspondant à des régions inactives pour ce capteur.

Un autre but de l'invention est de fournir un procédé de détection des positions angulaires de N roues coaxiales pouvant être appliqué au dispositif selon l'invention de manière efficace et sûre, c'est-à-dire assurant une bonne précision dans la détection de ces positions angulaires.

A cet effet, la présente invention concerne un procédé de détection des positions angulaires de N roues coaxiales, N étant supérieur à 1, au moyen d'un seul et même capteur inductif ou capacitif, ces N roues comprenant respectivement N plateaux présentant chacun au moins une région inactive pour ledit capteur qui comprend un organe de détection de matériaux actifs formant au moins partiellement chacun desdits N plateaux, cet organe de détection et chacune desdites régions inactives étant agencés de manière qu'ils soient superposés l'un à l'autre dans au moins une position angulaire déterminée de la roue présentant cette région inactive, lesdits N plateaux définissant chacun un demi-axe géométrique de référence détectable par ledit capteur, ce procédé consistant en les étapes successives suivantes où les N plateaux sont numérotés dans un ordre croissant depuis le plateau situé le plus proche dudit organe de détection jusqu'au plateau le plus éloigné de cette organe de détection :
A) Déterminer la position angulaire dudit demi-axe de la roue N°1;
B) Amener ou laisser ladite région inactive de la roue N°1 en superposition avec ledit organe de détection, ou attendre que cette région inactive et cet organe de détection soient superposés l'un à l'autre;
C) Effectuer les étapes A) et B) successivement pour les roues 2 à (N-1), le cas échéant;
D) Déterminer la position angulaire dudit demi-axe de la roue N.

Grâce aux caractéristiques de ce procédé, il est possible de détecter à l'aide d'un seul et même capteur inductif ou capacitif au moins une position angulaire de référence de chacune des roues coaxiales d'un dispositif, notamment d'un mouvement horloger.

La présente invention sera décrite ci-après plus en détail, en référence aux dessins annexés à titre d'exemples nullement limitatifs dans lesquels :
- la figure 1 est une vue schématique en plan de deux roues coaxiales associées à un capteur inductif;
- la figure 2 est une vue en coupe selon la ligne II-II de la figure 1, les aiguilles n'ayant pas été représentées alors que d'autres éléments du dispositif de la figure 1 sont représentés;
- la figure 3 représente schématiquement une courbe de mesure du type pouvant être obtenue à l'aide de signaux de mesure fournis par le capteur du dispositif des figures 1 et 2, cette courbe permettant de déterminer la position angulaire de référence de l'une ou l'autre des deux roues coaxiales;
- la figure 4 représente schématiquement en plan un deuxième mode de réalisation selon l'invention;
- la figure 5 est une vue en coupe similaire à la figure 2 selon la ligne V-V de la figure 4;
- la figure 6 représente schématiquement une courbe obtenue à l'aide de signaux de mesure fournis par le capteur du dispositif des figures 4 et 5, permettant de déterminer la position angulaire de référence de l'une ou l'autre des deux roues coaxiales de ce dispositif;
- la figure 7 est une vue en coupe, similaire à celle de la figure 5, d'un troisième mode de réalisation du dispositif selon l'invention;
- la figure 8 est une vue en coupe, similaire à la figure 5, d'un quatrième mode de réalisation du dispositif selon l'invention;
- la figure 9 représente schématiquement une variante de réalisation des roues coaxiales des dispositifs représentés aux figures précédentes;
- la figure 10 représente schématiquement une courbe obtenue à l'aide de signaux de mesure lors d'une transition entre une partie pleine et une ouverture de la roue représentée à la figure 9.

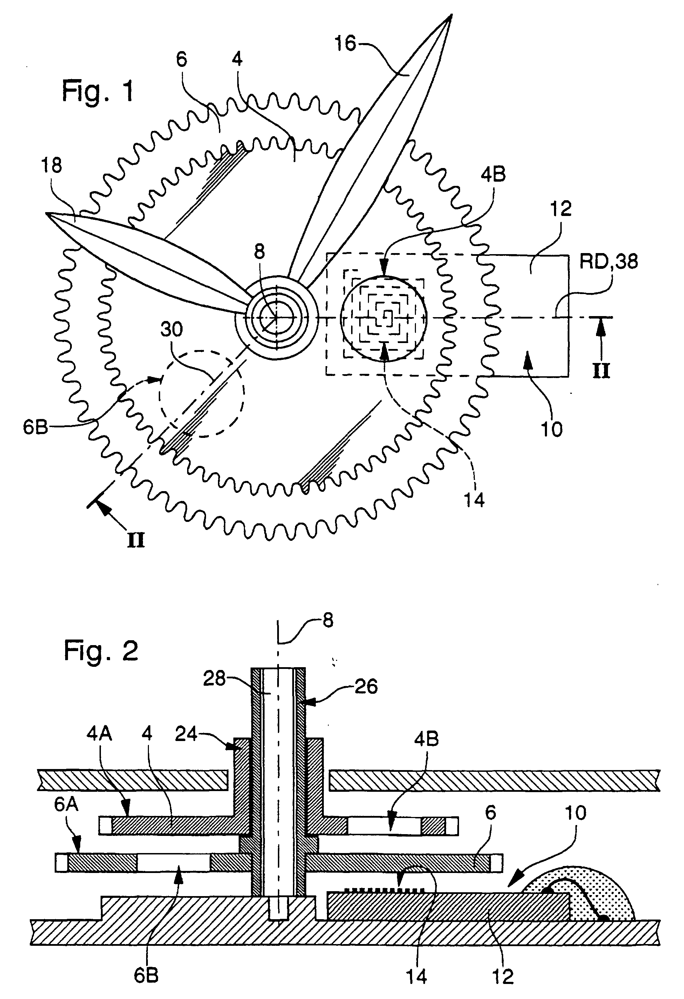

A l'aide des figure 1 à 3, on décrira ci-après un premier mode de réalisation d'un dispositif selon l'invention et un mode de détection de la position angulaire des deux roues coaxiales qui lui est associé.

Le dispositif comprend deux roues coaxiales 4 et 6, montées rotatives autour d'un même axe géométrique de rotation 8. Ces deux roues présentent respectivement deux plateaux 4A et 6A parallèles l'un à l'autre et perpendiculaires à l'axe géométrique 8. Afin de déterminer les positions angulaires respectives de deux demi-axes de référence associés respectivement aux deux plateaux 4A et 6A, il est prévu un capteur inductif 10 comprenant un support 12 sur une face duquel est agencé un organe de détection de présence du matériau formant les plateaux 4 et 6 au-dessus de cet organe de détection. Cet organe de détection est formé par une bobine plane en spirale 14. Au capteur 10 sont associées deux ouvertures 4B et 6B prévues respectivement dans les plateaux 4A et 6A. On notera que dans un mode de réalisation non représenté, la bobine peut être formée par un enroulement autoporteur.

Les roues 4 et 6 sont respectivement associées à deux aiguilles 16 et 18 d'un affichage analogique. Les axes cylindriques 24 et 26 des roues 4 et 6 sont montées rotatifs autour d'un axe central 28.

Les plateaux 4A et 6A sont formés de matériaux actifs pour le capteur 10, c'est-à-dire de matériaux dont la présence à proximité de l'organe de détection 14 est détectée par le capteur inductif 10. Les ouvertures 4B et 6B définissent des premières et deuxièmes régions inactives des plateaux 4A et 6A. Dans le cas préféré où ces régions inactives sont formées par des ouvertures, l'absence de matière en superposition avec la bobine 14 engendre un signal de mesure différent de celui fourni en présence de matériaux actifs formant les plateaux 4A et 6A en superposition avec cette bobine 14.

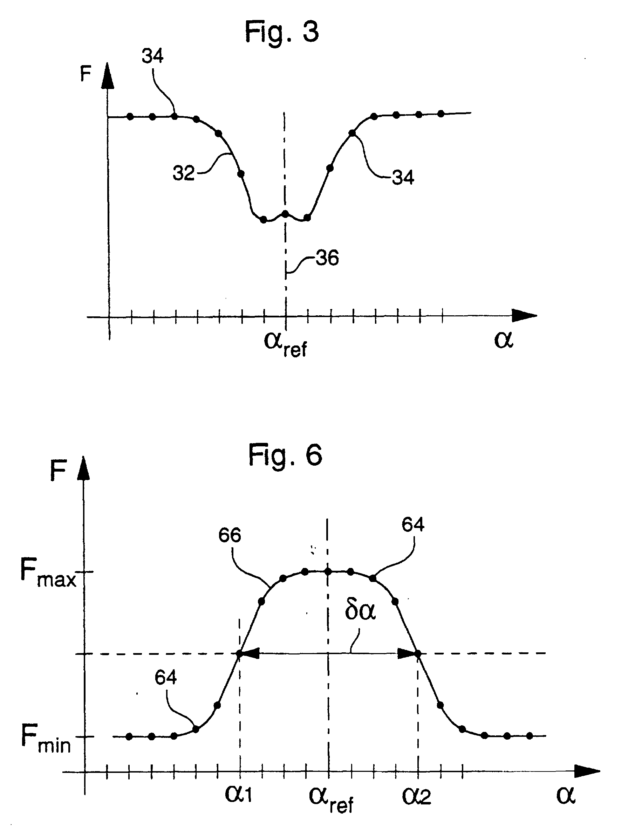

On décrira premièrement la détection du demi-axe de référence 30 de la roue 6 dont le plateau 6A est le plus proche de l'organe de détection 14. Pour ce faire, on se référera à la figure 3 correspondant à la figure 3 de la demande de brevet EP-A-0 952 426.

Cette figure 3 représente schématiquement une courbe 32 obtenue par une succession de points de mesure 34 fournis par le capteur inductif 10 lors du passage de l'ouverture 6B au-dessus de la bobine 14. Le capteur inductif prévu dans ce mode de réalisation comprend un circuit électronique similaire à celui décrit dans le document EP 0 746 100, ce capteur définissant un oscillateur à relaxation différentiel. Le signal de mesure fourni par un tel capteur est représentatif d'une fréquence déterminée par le circuit électronique de ce capteur, cette fréquence variant en fonction de la variation de présence du matériau actif constituant le plateau 6A au-dessus de la bobine 14. Lorsque cette bobine 14 est en regard du matériau actif constituant le plateau 6A, la fréquence a une valeur haute. Par contre, lorsque la bobine 14 est située sensiblement en regard de l'ouverture 6B, la fréquence est basse. La courbe 32 définit schématiquement l'évolution de la valeur de la fréquence engendrée dans le capteur en fonction de la position angulaire du demi-axe de référence 30 de la roue 6 qui part de l'axe géométrique 8 et passe par le centre géométrique de l'ouverture circulaire 6B.

On remarquera que la courbe 32 est sensiblement symétrique relativement à l'axe 36 correspondant à la valeur α=α_{ref}. Ainsi, à l'aide d'une analyse appropriée de l'évolution des points de mesure 34 en fonction de la position angulaire α du demi-axe 30 passant au-dessus ou au-dessous de la bobine 14, il est possible de déterminer quelle mesure correspond à la position angulaire α=α_{ref} du demi-axe 30, c'est-à-dire lorsque ce dernier est sensiblement confondu ou superposé à un demi-axe de référence RD du capteur 10 qui part de l'axe géométrique 8 et croise l'axe magnétique de la bobine 14, lequel est parallèle à l'axe 8 et passe sensiblement par le centre géométrique de cette bobine 14.

On notera que la largeur du creux du graphe 32 (ou du pic dans une autre variante de réalisation du circuit électronique du capteur 10) est fonction du profil de l'ouverture 6B et en particulier de la dimension angulaire de cette ouverture. Une fois que l'ouverture 6B a passé au-dessus de la bobine 14, grâce à des moyens d'entraînement prévu et connu de l'homme du métier, la mesure de la position angulaire correspondant à α_{ref} peut être déterminée par des moyens électroniques également connu de l'homme du métier. On citera par exemple le calcul du point milieu de la largeur du creux de la courbe 32 à une profondeur caractéristique.

Une fois la position angulaire du demi-axe 30 déterminée, il est prévu selon l'invention d'amener ou de laisser l'ouverture 6B en superposition avec la bobine 14, ou d'attendre que cette ouverture 6B soit superposée à cette bobine 14 pour détecter la position angulaire du demi-axe de référence 38 associé à la roue 4, ce dernier demi-axe 38 partant de l'axe géométrique 8 est passant par le centre géométrique de l'ouverture 4B prévu dans le plateau 4A. De préférence, il est prévu que l'ouverture 6B ait des dimensions suffisamment grandes de manière que la bobine spirale 14 soit en majeure partie au-dessus ou au-dessous de cette ouverture 6B, définissant une région inactive du plateau 6A, dans au moins une position angulaire déterminée de la roue 6, à savoir dans le présent cas lorsque les demi-axes 30 et RD sont sensiblement confondus ou superposés l'un à l'autre.

Ainsi, selon l'invention, il est prévu pour détecter la position angulaire du demi-axe de référence 38 du plateau 4A plus éloigné de la bobine 14 que le plateau 6A, d'amener ou d'attendre que l'ouverture 6B du plateau 6A le plus proche de cette bobine 14 soit sensiblement en regard de celle-ci. Ensuite, il est prévu d'amener ou d'attendre que l'ouverture 4B passe au-dessus de la bobine 14 et, par conséquent, également au-dessus de l'ouverture 6B pour détecter la position angulaire du demi-axe 38. Pour ce faire, une succession de mesures similaires à celles représentées à la figure 3 est effectuée et l'analyse de la courbe résultante similaire à la courbe 34 permet aux moyens de détection de déterminer quelle mesure correspond à la position angulaire α=α_{ref} pour le demi-axe 38. Cette succession de mesures et l'analyse de la courbe résultante sont rendues possible par le fait que le plateau 6 présente une région inactive au-dessus de la bobine 14 lors de la détection du passage de l'ouverture 4B au-dessus (ou au-dessous) de la bobine 14 du capteur 10 qui répond à une variation de présence des matériaux actifs constituants les plateaux 4A et 6A au-dessus ou au-dessous de son organe de détection par une variation d'une fréquence d'oscillation propre du capteur 10 dont dépend le signal de mesure fourni par ce capteur.

On notera que, pour la deuxième ouverture 4B appartenant au plateau 4 le plus éloigné de l'organe de détection 14, le creux dans la courbe de mesure similaire à la courbe 32 peut être défini par un seul point de mesure, notamment en diminuant la dimension angulaire de l'ouverture 4B, cette ouverture pouvant présenter notamment la forme d'une fente radiale. Il est possible de déterminer une valeur inférieure de seuil pour la fréquence F au-dessous de laquelle un point de mesure indique que l'axe géométrique de la fente est sensiblement aligné sur l'axe de référence RD du capteur 10. Dans un tel cas, la position angulaire de la roue 4 est déterminée directement par une seule valeur de mesure correspondant à la position angulaire α_{ref} pour le demi-axe 38, lequel est alors confondu ou superposé au demi-axe de référence RD. On remarquera qu'un tel cas particulier simplifie le traitement des résultats de mesure pour la détection de la position angulaire de la roue 4.

On notera toutefois que l'ouverture 6B usinée dans le plateau 6A peut présenter des dimensions nettement inférieures à celles de la bobine 14 sans pour autant empêcher au capteur 10 de détecter la position angulaire du demi-axe de référence associé à la roue 4, et donc sans sortir du cadre de la présente invention. Toutefois, dans un tel cas l'efficacité de la mesure est diminuée, c'est-à-dire que la variation de fréquence risque d'être moins contrastée. Théoriquement, la condition minimale à la présente invention est donnée par la nécessité que les deux ouvertures 4B et 6B et la bobine spirale 14 soient superposées les unes aux autres dans au moins une situation, c'est-à-dire dans au moins une première position angulaire déterminée de la roue 6 et dans au moins une deuxième position angulaire déterminée de la roue 4. Par contre, pour assurer une plus grande efficacité de mesure pour le capteur 10, et étant donné l'éloignement du plateau 4 de la bobine 14, il est préférable que l'ouverture 6B présente des dimensions au moins comparables à celles de la bobine 14 de manière qu'au moins la majeure partie de cette bobine soit située en regard de l'ouverture 6B dans ladite au moins première position angulaire déterminée de la roue 6.

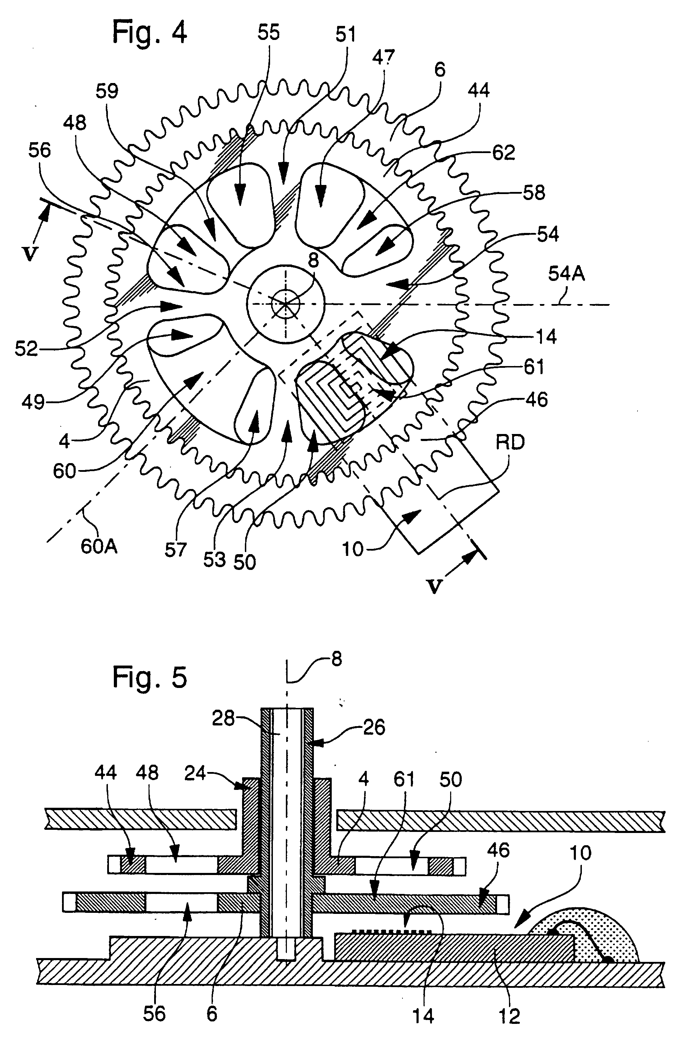

Aux figures 4 et 5 est représenté un deuxième mode de réalisation d'un dispositif selon l'invention. Ce dispositif comporte un capteur 10 dont l'organe de détection est formé par une bobine spirale 14 de manière équivalente au premier mode de réalisation décrit ci-avant. Les références déjà décrites ne seront pas à nouveau décrites ici en détail. Ce deuxième mode de réalisation se distingue du premier essentiellement dans l'agencement des plateaux 44 et 46 des roues coaxiales 4 et 6. Le plateau 44 présente quatre ouvertures 47 à 50 qui définissent quatre bras 51 à 54, le bras 54 ayant une largeur/dimension angulaire supérieure à celle des bras 51 à 53 qui sont sensiblement identiques l'un à l'autre. Le plateau 46 présente également quatre ouvertures 55 à 58 agencées à une même distance de l'axe géométrique 8 que les ouvertures correspondantes 47 à 50 du plateau 44. Les ouvertures 55 à 58 définissent également quatre bras radiaux 59 à 62, le bras 60 ayant une largeur/dimension angulaire supérieure à celle des bras 59, 61 et 62 qui sont sensiblement identiques. La ligne médiane du bras radial 54 définit un demi-axe de référence 54A du plateau 44, alors que la ligne médiane du bras radial 60 définit un demi-axe de référence 60A du plateau 46.

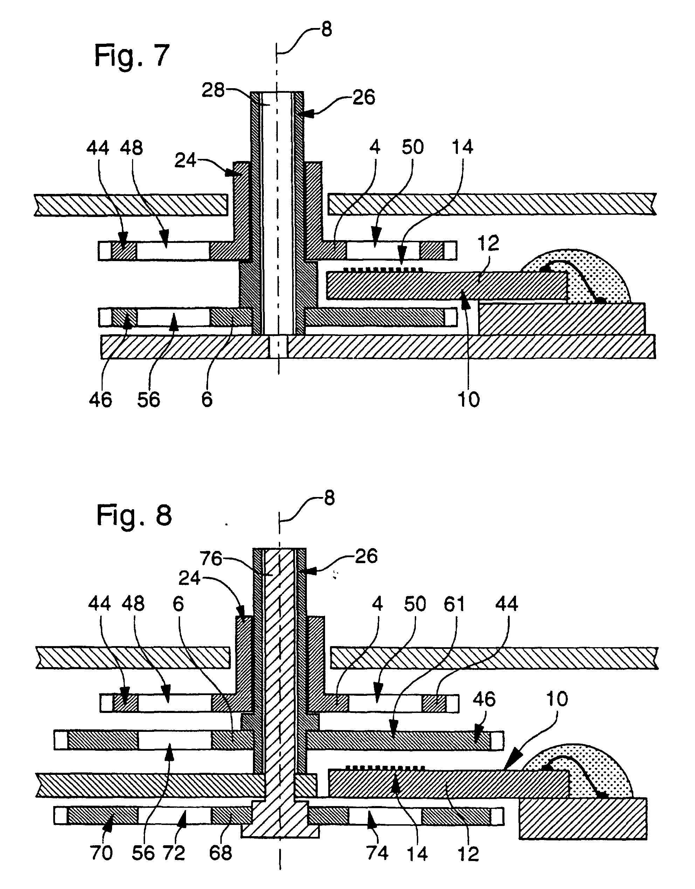

Dans ce deuxième mode de réalisation, il est prévu de détecter le passage du bras 60, respectivement 54 pour détecter la position angulaire de la roue 6, respectivement 4. Pour ce faire, on détecte le passage du bras 60, respectivement 54 au-dessus de la bobine spirale 14 du capteur inductif 10. A nouveau, on détecte premièrement la position angulaire du plateau 46 qui est le plus proche de la bobine 14. En se référant à la figure 6, plusieurs mesures successives 64 sont effectuées lors de la rotation du plateau 46 jusqu'à ce que le bras 60 passe par dessus la bobine 14. Les mesures successives 64 définissent une courbe 66 sensiblement symétrique. Lorsqu'une des ouvertures 47 à 50 est située en regard de la bobine 14, la fréquence interne de l'oscillateur formant le capteur 10 correspond sensiblement à Fₘᵢₙ. Par contre, lorsque le bras 60 est situé en regard de la bobine 14, la fréquence augmente jusqu'à une valeur Fₘₐₓ.

Etant donné la symétrie du bras 60 et la symétrie résultante de la courbe 66, deux paramètres caractéristiques peuvent être déduits par un circuit électronique du capteur 10, à savoir la position angulaire correspondant au milieu du pic engendré par le passage devant la bobine 14 du bras 60 et la largeur angulaire δα à mi-hauteur du pic, δα = α2-α1. La mesure de δα permet de différencier le bras 60 des trois autres bras 59, 61 et 62 qui présentent chacun une dimension angulaire inférieure. La détection du bras 60 pourrait éventuellement être déterminée par la valeur de Fₘₐₓ qui sera probablement supérieure lors du passage du bras 60 relativement au passage des trois autres bras du plateau 46.

La détermination de α_{ref} permet de déterminer lorsque le demi-axe 60A est aligné sur le demi-axe de référence RD du capteur 10, c'est-à-dire lorsque les deux demi-axes 60A et RD sont confondus ou superposés l'un à l'autre. Ainsi, en gardant en mémoire l'évolution temporelle de la rotation du plateau 46, le circuit électronique de détection des positions angulaires des roues 4 et 6 peut connaître la position angulaire instantanée du plateau 46 une fois que le moment ou la mesure correspondant à la position angulaire α_{ref} du demi-axe 60A a été déterminée.

Une fois la position angulaire de la roue 6 déterminée, le plateau 46 est entraîné en rotation ou laissé de manière que la bobine 14 soit superposée au moins en majeure partie à l'une des ouvertures 55 à 58 du plateau 46. Dans un autre mode de détection de la position de la roue 4, il est prévu d'attendre jusqu'à ce que la bobine 14 soit située en regard de l'une des ouvertures 55 à 58 pour procéder à la détection de la position angulaire de la roue 4. Comme une ouverture définit une région inactive pour le capteur 10, celui-ci détecte alors le passage des bras du plateau 44 qui est le plus éloigné de la bobine 14. La détection du passage du bras radial 54 et la détermination de la position angulaire du demi-axe de référence 54A correspondant à α_{ref} sont effectuées de manière similaire a ce qui a été expliqué en détail ci-avant pour la roue 6 à l'aide de la figure 6.

Ainsi, la détection des positions angulaires des deux roues coaxiales 4 et 6 est effectuée à l'aide d'un seul et même capteur 10 qui est selon l'invention inductif ou capacitif. Dans le cas d'un capteur capacitif, l'organe de détection sera formé par une électrode située à la surface du substrat. Les roues et en particulier les plateaux de ces roues seront agencés de manière à ce qu'il y ait une variation de capacité en fonction de la présence d'une ouverture ou d'une partie pleine en regard de l'organe de détection.

Pour garantir une détection précise des positions angulaires des roues 4 et 6, il est proposé selon un perfectionnement de l'invention d'effectuer un contrôle consistant à amener ou laisser la roue 4 dans une position dans laquelle la bobine 14 est superposée au moins en majeurs partie à l'une des ouvertures 47 à 50 du plateau 44, puis d'entraîner en rotation le plateau 46 de manière à ce que le bras radial 60 passe au-dessus de la bobine 14 en effectuant à nouveau une succession de mesures permettant de déterminer en toute sécurité le passage du demi-axe 60A sur le demi-axe RD correspondant à la position angulaire α_{ref}. Cette mesure peut être plus précise que la première effectuée étant donné que, lors de cette première mesure, la position angulaire exacte de la roue 4 n'était pas connue et qu'il est possible qu'un des bras 51 à 54 du plateau 44 ait été situé sensiblement en regard de la bobine 14; ce qui peut créer une certaine dissymétrie dans la courbe représentée à la figure 6 et obtenue sur la base de mesures successives.

Une fois le contrôle de la position angulaire de la roue 6 effectuée, on conserve le résultat de cette seconde détection pour la position angulaire de cette roue 6. Finalement, selon une variante du procédé de détection selon l'invention, il est possible de contrôler encore la position angulaire de la roue 4 ayant le plateau 44 le plus éloigné de la bobine 14. Etant donné que la position angulaire de la roue 6 est màintenant connue de manière précise, il est possible d'assurer que la détection de la position angulaire de la roue 4 soit effectuée lorsque le plateau de la roue 6 est positionné angulairement de manière à ce que la bobine 14 soit au moins en majeure partie superposée à une ouverture du plateau 46. On notera qu'un tel contrôle s'avère judicieux particulièrement lorsque le contrôle de la position angulaire de la roue 6 a montré une différence entre la détection initiale et la détection de contrôle pour la roue 6.

A la figure 7 est représenté un troisième mode de réalisation de l'invention. Les plateaux 44 et 46 des roues coaxiales 4 et 6 respectives sont identiques à ceux des figures 4 à 5 décrites ci-avant. Ce troisième mode de réalisation se distingue du deuxième mode de réalisation en ce que le substrat 12 du capteur 10 présentant sur sa face supérieure la bobine 14 est agencé entre les plateaux 44 et 46. Dans ce cas-ci, le plateau 44 est le plus proche de la bobine 14. On notera toutefois que le substrat 12 peut être retourné dans une variante de réalisation de telle manière que la bobine 14 soit située sous le substrat 12 en regard du plateau 46. Le procédé de détection de la position angulaire des deux roues 4 et 6 est similaire à celui décrit ci-avant. L'agencement de ce troisième mode de réalisation peut être avantageux étant donné que les plateaux 44 et 46 sont situés de part et d'autre de la bobine plane 14.

A la figure 8 est représenté un quatrième mode de réalisation du dispositif selon l'invention. Ce dispositif comporte trois roues coaxiales 4, 6 et 68 associées à un seul et même capteur 10 servant à la détection des positions angulaires de ces trois roues coaxiales. Les roues 4 et 6 sont similaires aux roues 4 et 6 du deuxième mode de réalisation décrit ci-avant à l'aide des figures 4 et 5, ces deux roues étant situées relativement au capteur 10 de manière identique. La troisième roue 68 comporte un plateau 70 parallèle aux plateaux 44 et 46. Ce plateau 70 présente des mêmes ouvertures que les plateaux 44 et 46. Ainsi, le plateau 70 définit également quatre bras radiaux avec un de ces bras présentant une largeur/dimension angulaire supérieure aux autres. Les ouvertures dans le plateau 70, dont deux 72 et 74 sont représentées sur la coupe de la figure 8, sont agencées radialement de manière identique aux ouvertures des plateaux 44 et 46.

Au cas où les roues ont des diamètres différents et présentent des ouvertures ayant des dimensions radiales différentes d'un plateau à l'autre, il suffit de s'assurer qu'au moins une ouverture de chaque plateau et l'organe de détection 14 sont superposés l'un aux autres dans au moins une position déterminée de la roue correspondante.

La détection des positions angulaires des roues 4 et 6 se fait de manière similaire à celui décrit dans le cadre du deuxième mode de réalisation. Il en va de même pour la roue 68 dont l'agencement relativement au capteur 10 est similaire à celui de la roue 6 du troisième mode de réalisation décrit à l'aide de la figure 7. On notera toutefois que le plateau 46 est le plus proche de la bobine 14, alors que le plateau 44 est le plus éloigné de cette bobine 14.

Ainsi, selon le procédé de détection de la position des trois roues coaxiales selon l'invention, il est prévu de déterminer en premier la position angulaire de la roue 6 comme décrit précédemment, puis d'amener ou de laisser le plateau 46 dans une position angulaire dans laquelle la bobine 14 est superposée en majeure partie à une ouverture du plateau 46. Ensuite, on détermine la position angulaire de la roue 68 dont le plateau 70 est situé en dessous de la bobine 14, à une distance inférieure de celle du plateau 44. Une fois le demi-axe de référence du plateau 70 détecté et donc la position angulaire de la roue 68 déterminée, le plateau 70 est amené ou laissé dans une position angulaire où la bobine 14 est superposée à une ouverture du plateau 70, notamment à l'ouverture 74. Finalement, la position angulaire de la roue 4 est détectée par le capteur 10, le plateau 46 étant toujours dans une position angulaire où la bobine 14 est superposée à une ouverture de ce plateau 46. De préférence, l'ouverture du plateau 70 située en regard de la bobine 14 lors de la détection de la position angulaire de la roue 4 présente également des dimensions suffisantes pour que la majeure partie de la bobine 14 soit superposée à cette ouverture dans au moins une position angulaire déterminée de la roue 68. Le plateau 70 de la roue 68 est constitué d'un matériau actif pour le capteur 10, tout comme les plateaux 44 et 46.

Un contrôle des positions angulaires des trois roues coaxiales en commençant par le plateau le plus proche de la bobine 14 jusqu'au plateau le plus éloigné peut être effectué de manière équivalente au cas décrit ci-avant avec deux roues. Pour ce faire, il est prévu d'amener ou de laisser les autres plateaux dans des positions angulaires où la bobine 14 est au-dessus ou au-dessous d'une ouverture de chacun de ces autres plateaux, ou d'attendre que le dispositif se trouve dans une telle situation.

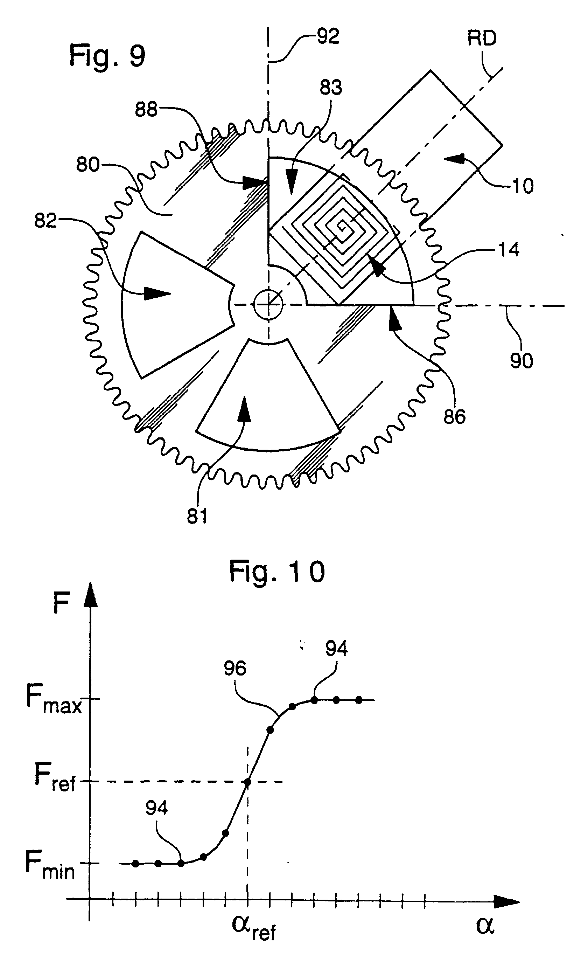

A la figure 9 est représentée une variante du plateau de la roue 4, respectivement 6 et 68. Ce plateau 80 présente trois ouvertures 81, 82 et 83 formant des secteurs annulaires séparés par trois parties matérielles définissant également trois secteurs annulaires. Ainsi, les bords radiaux des ouvertures 81 à 83 et des parties matérielles intermédiaires définissent des segments radiaux du plateau 80. A titre d'exemple, les deux segments radiaux 86 et 88 définissent respectivement deux demi-axes de référence 90 et 92 du plateau 80. Chacun de ces deux demi-axes de référence peut être détecté par les moyens de détection à l'aide de mesures successives 94 définissant une courbe en S 96 représentée à la figure 10.

Lors du passage d'une partie pleine à l'ouverture 83 où de cette ouverture 83 à une partie pleine du plateau 80 au-dessus de la bobine plane 14, la fréquence de l'oscillateur du capteur 10 passe de Fₘᵢₙ à Fₘₐₓ ou l'inverse suivant l'agencement du circuit électronique définissant l'oscillateur du capteur 10. L'alignement du demi-axe de référence 90, respectivement 92 sur le demi-axe de référence RD du capteur 10, correspondant à l'angle de référence α_{ref,} correspond au point milieu de la courbe en S 96. α_{ref} correspond une fréquence de résonance F_{ref}.

Ainsi, lorsque la fréquence de l'oscillateur correspond à F_{ref}, l'alignement d'un bord radial d'une ouverture 81 à 83 sur le demi-axe RD est détectée. Dans le cas du plateau 80, il est encore nécessaire de déterminer les largeurs angulaires entre deux transitions. Etant donné que seule l'ouverture 83 définit un angle de 90°, et pour autant que le sens de rotation du plateau 80 soit connu, il est possible de déterminer de manière univoque la position angulaire du demi-axe 90, respectivement 92. De plus, étant donné que les trois bras radiaux séparant les ouvertures n'ont pas tous une largeur angulaire identique, le demi-axe 90, respectivement 92 peut être détecté de manière univoque sans nécessiter également de détecter l'autre de ces demi-axes.

On notera encore que le plateau 80 définit une pluralité de demi-axes de référence dont au moins six peuvent être exploités de manière sûre et efficace.

## Revendications

1. Dispositif de petites dimensions, notamment du type horloger, comprenant une première roue (6; 4) et une deuxième roue (4; 6; 68) coaxiales, montées rotatives autour d'un même axe géométrique de rotation (8) et comportant respectivement un premier plateau (6A, 46; 44) et un deuxième plateau (4A, 44; 46; 70) perpendiculaires à cet axe géométrique de rotation (8), ce dispositif comprenant en outre des moyens de détection (10) des positions angulaires d'un premier demi-axe géométrique de référence (30; 60A) de ladite première roue (6; 4) et d'un deuxième demi-axe géométrique de référence (38; 54A) de ladite deuxième roue (6A, 46; 44), ce dispositif étant **caractérisé en ce que** lesdits moyens de détection (10) des positions angulaires desdits premier et deuxième demi-axes sont constitués par un seul et même capteur inductif ou capacitif (10) pourvu d'un organe de détection (14) de la présence de matériau(x) actif(s) au-dessus ou au-dessous de cet organe (14), ledit premier plateau (6A, 46; 44) comprenant au moins une région inactive (6B, 55 à 58; 47 à 50) pour ledit capteur (10), lesdits premier et deuxième plateaux étant formés au moins partiellement de matériau(x) actif(s) pour ledit capteur (10), ce capteur (10) étant agencé relativement à ladite première roue (6; 4) de manière que son organe de détection (14) soit au moins en partie au-dessus ou au-dessous de ladite première région inactive (6B, 55 à 58; 47 à 50) dans au moins une position angulaire déterminée de cette première roue (6; 4).

2. Dispositif selon la revendication 1, **caractérisé en ce que** ledit capteur (10) répond à une variation de présence d'un matériau actif au-dessus ou au-dessous dudit organe de détection (14) par une variation d'au moins un paramètre ou d'une variable de ce capteur (10) dont dépend un signal de mesure fourni par celui-ci, ladite première région inactive (6B, 55 à 58; 47 à 50) ayant des dimensions prévues pour que ledit organe de détection (14) soit au moins en majeure partie en regard de cette première région inactive (6B, 55 à 58; 47 à 50) dans ladite position angulaire déterminée.

3. Dispositif selon la revendication 1 ou 2, **caractérisé en ce que** ladite première région inactive est définie par une première ouverture (6B, 55 à 58; 47 à 50) prévue dans ledit premier plateau (6A, 46; 44).

4. Dispositif selon la revendication 3, **caractérisé en ce que** lesdits premier et deuxième plateaux sont constitués par des matériaux actifs pour ledit capteur (10), le deuxième plateau (4A, 44; 46; 70) présentant au moins une deuxième ouverture (4B, 47 à 50; 55 à 58; 72, 74), ledit organe de détection (14) étant agencé de manière qu'il soit au moins partiellement au-dessus ou au-dessous de cette deuxième ouverture dans au moins une position angulaire déterminée de ladite deuxième roue (4; 6; 68).

5. Dispositif selon la revendication 4, **caractérisé en ce que** ledit premier (30; 60A), respectivement ledit deuxième (38; 54A) demi-axe est défini par un rayon partant dudit axe géométrique de rotation (8) et soit passant sensiblement par le centre géométrique de ladite première (6B), respectivement deuxième (4B) ouverture, soit défini par un bord radial (86, 88) de ladite première, respectivement deuxième ouverture (83), soit confondu avec une ligne médiane d'une partie en matériau actif dudit premier (46), respectivement deuxième (44) plateau s'étendant radialement entre deux régions inactives de ce premier, respectivement deuxième plateau.

6. Dispositif selon l'une des revendications précédentes **caractérisé en ce que** ledit capteur (10) comprend un support (12) à la surface duquel est agencé ledit organe de détection (14), ce support (12) étant agencé en regard dudit premier plateau (6A; 46), ledit deuxième plateau (4A; 44) étant situé de l'autre côté de ce premier plateau relativement audit support (12), ledit capteur (10) étant agencé pour détecter la présence au-dessus dudit organe de détection (14) du matériau actif formant au moins partiellement ledit deuxième plateau (4A; 44) lorsque ladite première roue (6) se trouve dans ladite position angulaire déterminée.

7. Dispositif selon l'une des revendications 1 à 5, **caractérisé en ce que** ledit capteur (10) comprend un support (12) à la surface duquel est agencé ledit organe de détection (14), ce support (12) étant agencé entre lesdits premier et deuxième plateaux (44, 46; 46, 70), ledit organe de détection étant situé en regard dudit premier plateau (44; 46).

8. Dispositif selon la revendication 7, **caractérisé en ce qu'**il comprend en outre une troisième roue (4) coaxiale auxdites première et deuxième roues (6; 68) et comportant un troisième plateau (44) perpendiculaire audit axe géométrique de rotation (8), cette troisième roue (4) définissant un troisième demi-axe géométrique de référence dont la position angulaire est détectable par ledit capteur inductif ou capacitif (10), ledit troisième plateau (44) étant situé de l'autre côté dudit premier plateau (46) relativement audit support (12) dudit capteur (10) et étant formé au moins partiellement d'un matériau actif pour ce capteur (10), ce dernier étant agencé pour détecter la présence au-dessus ou au-dessous dudit organe de détection (14) de matériau(x) actif(s) formant au moins partiellement ledit troisième plateau (44) lorsque ladite première roue (6) se trouve dans ladite position angulaire déterminée.

9. Dispositif selon la revendication 8, **caractérisé en ce que** ledit deuxième plateau (70) comprend au moins une deuxième région inactive (72, 74) pour ledit capteur (10), agencé de manière que ledit organe de détection (14) soit au moins en majeure partie au-dessus ou au-dessous de cette deuxième région inactive (72, 74) dans au moins une position angulaire déterminée de cette deuxième roue (68).

10. Dispositif selon la revendication 8 ou 9, **caractérisé en ce que** ledit troisième plateau (44) est constitué par un matériau actif et présente une troisième ouverture (47 à 50), ledit organe de détection (14) étant agencé de manière qu'il soit au moins partiellement au-dessus ou au-dessous de cette troisième ouverture (47 à 50) dans au moins une position angulaire déterminée de ladite troisième roue (4), ledit troisième demi-axe étant défini par un rayon partant dudit axe géométrique de rotation (8) et soit passant sensiblement par le centre géométrique de ladite troisième ouverture (47 à 50), soit défini par un bord radial de cette troisième ouverture (47 à 50), soit confondu avec une ligne médiane d'une partie en matériau actif dudit troisième plateau (44) s'étendant radialement entre deux régions inactives de ce troisième plateau (44).

11. Procédé de détection des positions angulaires de N roues coaxiales, N étant supérieur à 1, au moyen d'un seul et même capteur inductif ou capacitif (10), ces N roues comprenant respectivement N plateaux présentant chacun au moins une région inactive pour ledit capteur qui comprend un organe de détection (14) de matériau(x) actif(s) formant au moins partiellement chacun desdits N plateaux, cet organe de détection (14) et chacune desdites régions inactives étant agencée de manière qu'ils soient superposés l'un à l'autre dans au moins une position angulaire déterminée de la roue présentant cette région inactive, lesdits N plateaux définissant chacun un demi-axe géométrique de référence détectable par ledit capteur (10), ce procédé consistant en les étapes successives suivantes où les N plateaux sont numérotés dans un ordre croissant depuis le plateau situé le plus proche dudit organe de détection jusqu'au plateau le plus éloigné de cet organe de détection :
A) Déterminer la position angulaire dudit demi-axe de la roue N°1;
B) Amener ou laisser ladite région inactive de la roue N°1 en superposition avec ledit organe de détection, ou attendre que cette région inactive et cet organe de détection (14) soient superposés l'un à l'autre;
C) Effectuer les étapes A) et B) successivement pour les roues 2 à (N-1), le cas échéant;
D) Déterminer la position angulaire dudit demi-axe de la roue N.

12. Procédé selon la revendication 11, dans lequel il est prévu en plus les étapes successives suivantes :
E) Amener ou laisser la région inactive N°2 au cas ou N=2, respectivement les régions inactives des roues N°2 à N au cas ou N est supérieur à 2 en superposition avec ledit organe de détection, ou attendre que cette région inactive, respectivement ces régions inactives et cet organe de détection soient superposés l'un à l'autre, respectivement les uns aux autres;
F) contrôler la position angulaire dudit demi-axe de la roue N°1, et conserver la position angulaire résultant de ce contrôle au cas ou elle ne correspond pas à la position angulaire mesurée lors de l'étape A);
G) Effectuer dans l'ordre croissant pour chaque roue N°2 à (N-1), le cas échéant, un contrôle de la position angulaire du demi-axe associé à cette roue après avoir amené ou laissé les régions inactives des autres roues en superposition avec ledit organe de détection, ou avoir attendu que ces régions inactives et cet organe de détection soient superposés les uns aux autres, et conserver la position angulaire résultant de ce contrôle pour chaque roue N°2 à (N-1) au cas ou elle ne correspond pas à la position angulaire mesurée lors de l'étape C).

13. Procédé selon la revendication 12, dans lequel il est prévu une étape finale :
H) Contrôler la position angulaire du demi-axe associé à la roue N°N après avoir amené ou laissé ladite région inactive de la roue N°1 au cas ou N = 2, respectivement les régions inactives N°1 à (N-1) au cas ou N est supérieur à 2 en superposition avec ledit organe de détection, ou avoir attendu que cette région inactive, respectivement ces régions inactives et cet organe de détection (14) soient superposés l'un à l'autre, respectivement les uns aux autres, cette étape étant effectuée de préférence seulement si l'/les étape(s) de contrôle de la position angulaire, respectivement des positions angulaires, de la roue 1, respectivement des roues 1 à (N-1), ont montré au moins une détection erronée lors des étapes A) à C).

## Patentansprüche

1. Vorrichtung mit kleinen Abmessungen, insbesondere vom Zeitmeßtyp, mit einem ersten Rad (6; 4) und einem zweiten Rad (4; 6; 68), die koaxial und um eine selbe geometrische Rotationsachse drehbar montiert sind und eine erste Platte (6A, 46; 44) bzw. eine zweite Platte (4A, 44; 46; 70), die senkrecht zu der geometrischen Rotationsachse (8) sind, aufweisen, wobei die Vorrichtung ferner Erfassungsmittel (10) für Winkelpositionen einer ersten geometrischen Referenzhalbachse (30; 60A) des ersten Rads (6; 4) und einer zweiten geometrischen Referenzhalbachse (38; 54A) des zweiten Rads (6A, 46; 44) umfaßt, wobei die Vorrichtung **dadurch gekennzeichnet ist, daß** die Erfassungsmittel (10) für Winkelpositionen der ersten und zweiten Halbachsen aus ein und demselben induktiven oder kapazitiven Sensor (10) gebildet sind, der mit einem Erfassungselement (14) für das Vorhandenseins eines aktiven Materials oder aktiver Materialien unter oder über diesem Element (14) versehen ist, wobei die erste Platte (6A, 46; 44) wenigstens einen inaktiven Bereich (6B, 55 bis 58; 47 bis 50) für den Sensor (10) aufweist, wobei die erste und zweite Platte wenigstens teilweise aus einem oder mehreren aktiven Materialien für den Sensor (10) gebildet sind, wobei der Sensor (10) in bezug auf das erste Rad (6; 4) derart ausgestaltet ist, daß sein Erfassungselement (14) sich in wenigstens einer durch das erste Rad (6; 4) bestimmten Winkelposition wenigstens teilweise unter oder über dem ersten inaktiven Bereich (6B, 55 bis 58; 47 bis 50) befindet.

2. Vorrichtung nach Anspruch 1, **dadurch gekennzeichnet, daß** der Sensor (10) auf eine Änderung des Vorhandenseins eines aktiven Materials unter oder über dem Erfassungselement (14) durch eine Änderung wenigstens eines Parameters oder einer Variable des Sensors (10) reagiert, von dem bzw. der ein vom Sensor geliefertes Meßsignal abhängt, wobei der erste inaktive Bereich (6B, 55 bis 58; 47 bis 50) Abmessungen derart aufweist, daß das Erfassungselement (14) in der bestimmten Winkelposition wenigstens größtenteils dem ersten inaktiven Bereich (6B, 55 bis 58; 47 bis 50) gegenüberliegt.

3. Vorrichtung nach Anspruch 1 oder 2, **dadurch gekennzeichnet, daß** der erste inaktive Bereich durch eine erste Öffnung (6B, 55 bis 58; 47 bis 50) definiert wird, die in der ersten Platte (6A, 46; 44) vorgesehen ist.

4. Vorrichtung nach Anspruch 3, **dadurch gekennzeichnet, daß** die erste Platte und die zweite Platte aus aktiven Materialien für den Sensor (10) gebildet sind, wobei die zweite Platte (4A, 44; 46; 70) wenigstens eine zweite Öffnung (4B, 47 bis 50; 55 bis 58; 72, 74) aufweist, wobei das Erfassungselement (14) derart ausgestaltet ist, daß es sich in wenigstens einer durch das zweite Rad (4; 6; 68) bestimmten Winkelposition wenigstens teilweise unter oder über dieser zweiten Öffnung befindet.

5. Vorrichtung nach Anspruch 4, **dadurch gekennzeichnet, daß** die erste (30; 60A) bzw. die zweite (38, 54A) Halbachse durch einen Strahl definiert wird, der von der geometrischen Rotationsachse (8) ausgeht und sich entweder im wesentlichen durch das geometrische Zentrum der ersten (6B) bzw. zweiten (4B) Öffnung erstreckt, oder durch einen radialen Rand (86, 88) der ersten bzw. zweiten Öffnung (83) definiert wird, oder mit einer Mittellinie eines ersten Bereichs aktiven Materials der ersten (46) bzw. zweiten (44) Platte zusammenfällt, die sich radial zwischen zwei inaktiven Bereichen der ersten bzw. zweiten Platte erstreckt.

6. Vorrichtung nach einem der vorhergehenden Ansprüche, **dadurch gekennzeichnet, daß** der Sensor (10) einen Träger (12) an der Oberfläche aufweist, an der das Erfassungselement (14) angeordnet ist, wobei der Träger (12) gegenüber der ersten Platte (6A; 46) angeordnet ist, wobei die zweite Platte (4A; 44) bezüglich des Trägers (12) auf der anderen Seite der ersten Platte angeordnet ist, wobei der Sensor (10) zum Erfassen des Vorhandenseins aktiven Materials, das zumindest teilweise die zweite Platte (4A; 44) bildet, über dem Erfassungselement (14) ausgestaltet ist, während das erste Rad (6) sich in der bestimmten Winkelposition befindet.

7. Vorrichtung nach einem der Ansprüche 1 bis 5, **dadurch gekennzeichnet, daß** der Sensor (10) einen Träger (12) an der Oberfläche aufweist, an der das Erfassungselement (14) angeordnet ist, wobei der Träger (12) zwischen der ersten und der zweiten Platte (44, 46; 46, 70) angeordnet ist, wobei das Erfassungselement gegenüber der ersten Platte (44; 46) angeordnet ist.

8. Vorrichtung nach Anspruch 7, **dadurch gekennzeichnet, daß** sie zudem ein drittes Rad (4) aufweist, das zum ersten und zweiten Rad (6; 68) koaxial ist und eine dritte Platte (44) aufweist, die senkrecht zur geometrischen Rotationsachse (8) verläuft, wobei das dritte Rad (4) eine dritte geometrische Referenzhalbachse definiert, deren Winkelposition durch den induktiven oder kapazitiven Sensor (10) erfaßbar ist, wobei die dritte Platte (46) auf der anderen Seite der ersten Platte (46) relativ zum Träger (12) des Sensors (10) angeordnet und wenigstens teilweise aus einem aktiven Material für den Sensor (10) gebildet ist, wobei letzterer zum Erfassen des Vorhandenseins eines aktiven Materials oder aktiver Materialien über oder unter dem Erfassungsorgan (14) ausgestaltet ist, die die dritte Platte (44) wenigstens teilweise bilden, während das erste Rad (6) sich in der bestimmten Winkelposition befindet.

9. Vorrichtung nach Anspruch 8, **dadurch gekennzeichnet, daß** die zweite Platte (70) wenigstens einen zweiten inaktiven Bereich (72, 74) für den Sensor (10) aufweist, der derart ausgestaltet ist, daß sich das Erfassungselement (14) in wenigstens einer durch das zweite Rad (68) bestimmten Winkelposition, wenigstens größtenteils über oder unter dem zweiten inaktiven Bereich (72, 74) befindet.

10. Vorrichtung nach Anspruch 8 oder 9, **dadurch gekennzeichnet, daß** die dritte Platte (44) aus einem aktiven Material gebildet ist und eine dritte Öffnung (47 bis 50) aufweist, wobei das Erfassungselement (14) derart ausgestaltet ist, daß es sich zumindest teilweise über oder unter der dritten Öffnung (47 bis 50) in wenigstens einer vom dritten Rad (4) bestimmten Winkelposition befindet, wobei die dritte Halbachse durch einen Strahl definiert wird, der von der geometrischen Rotationsachse ausgeht und entweder sich im wesentlichen durch das geometrische Zentrum der dritten Öffnung (47 bis 50) erstreckt, oder von einem radialen Rand der dritten Öffnung (47 bis 50) definiert wird, oder mit einer Mittellinie eines Abschnitts aus aktivem Material der dritten Platte (44) zusammenfällt, die sich radial zwischen zwei inaktiven Bereichen der dritten Platte (44) erstreckt.

11. Verfahren zum Erfassen von Winkelpositionen von N koaxialen Rädern, wobei N größer als 1 ist, mittels eines einzigen und gleichen induktiven oder kapazitiven Sensors (10), wobei die N Räder entsprechend N Platten aufweisen, die jeweils wenigstens einen inaktiven Bereich für den Sensor aufweisen, der ein Erfassungsorgan (14) für ein aktives Material oder aktive Materialien umfaßt, die wenigstens teilweise jede der N-Platten bilden, wobei das Erfassungselement (14) und jeder der inaktiven Bereiche derart ausgestaltet sind, daß sie in wenigstens einer durch das den inaktiven Bereich aufweisende Rad bestimmten Winkelposition einander überlagert sind, wobei die N Platten jeweils eine geometrische Referenzhalbachse definieren, die vom Sensor (10) erfaßbar ist, wobei das Verfahren aus den aufeinanderfolgenden Schritten besteht, in denen die N Platten in einer Reihenfolge numeriert sind, die von der Platte, die am nächsten am Erfassungsorgan angeordnet ist, bis zu der Platte, die am weitesten von diesem Erfassungsorgan entfernt ist, ansteigt:
A) Bestimmen der Winkelposition der Halbachse des Rads Nr. 1;
B) Bringen oder Lassen des inaktiven Bereichs Nr. 1 in Überlagerung mit dem Erfassungselement oder Warten, bis der inaktive Bereich und das Erfassungselement (14) einander überlagern;
C) gegebenenfalls aufeinanderfolgendes Durchführen der Schritte A) und B) für die Räder 2 bis (N-1);
D) Bestimmen der Winkelposition der Halbachse des Rads (N).

12. Verfahren nach Anspruch 11, bei dem zudem die folgenden aufeinanderfolgenden Schritte vorgesehen sind:
E) Bringen oder Lassen des inaktiven Bereichs Nr. 2 in dem Fall, in dem N = 2, bzw. der inaktiven Bereiche der Räder Nr. 2 bis N, in dem Fall, in dem N größer als 2 ist, in Überlagerung mit dem Erfassungselement, oder Warten, bis der inaktive Bereich bzw. die inaktiven Bereiche und das Erfassungselement einander überlagern;
F) Steuern der Winkelposition der Halbachse des Rads Nr. 1 und Beibehalten der Winkelposition, die sich aus dieser Steuerung in dem Fall ergibt, in dem sie nicht der während des Schritts A) gemessenen Winkelposition entspricht;
G) gegebenenfalls Durchführen in aufsteigender Reihenfolge für jedes Rad Nr. 2 bis (N-1) ein Steuern der Winkelposition der Halbachse, die diesem Rad zugeordnet ist, nachdem die inaktiven Bereiche der anderen Räder mit dem Erfassungselement in Überlagerung gebracht oder gelassen worden sind, oder gewartet worden ist, bis die inaktiven Bereiche und das Erfassungselement einander überlagern, und Beibehalten der Winkelposition, die sich infolge der Steuerung jedes Rads Nr. 2 bis (N-1) ergibt, in dem Fall, wo sie nicht der im Schritt C) gemessenen Winkelposition entspricht.

13. Verfahren nach Anspruch 12, bei dem ein Endschritt vorgesehen ist:
H) Steuern der Winkelposition der Halbachse, die dem Rad Nr. N zugeordnet ist, nachdem man den inaktiven Bereich Nr. 1, in dem Fall, in dem N = 2, bzw. die inaktiven Bereiche Nr. 1 bis (N-1), in dem Fall, in dem N größer als 2 ist, in Überlagerung mit dem Erfassungsorgan gebracht oder gelassen hat oder gewartet hat, bis der inaktive Bereich bzw. die inaktiven Bereiche und das Erfassungselement (14) einander überlagern, wobei dieser Schritt vorzugsweise nur dann ausgeführt wird, wenn der/die Steuerschritt(e) der Winkelposition(en) des Rads 1 bzw. der Räder 1 bis (N-1) auf wenigstens eine fehlerhafte Erfassung während der Schritte A) bis C) hindeuten.

## Claims

1. Device of small dimensions, in particular of the horological type, including a first wheel (6; 4) and a second wheel (4; 6; 68) which are coaxial, rotatably mounted about a same geometrical axis of rotation (8) and respectively including a first plate (6A, 46; 44) and a second plate (4A, 44; 46; 70) perpendicular to said geometrical axis of rotation (8), this device further including means (10) for detecting the angular positions of a first reference geometrical semi-axis (30; 60A) of said first wheel (6; 4), and a second reference geometrical semi-axis (38; 54A) of said second wheel (6A, 46; 44), this device being **characterised in that** said means (10) for detecting the angular positions of said first and second semi-axes are formed by a single same inductive or capacitive sensor (10) provided with an element (14) for detecting the presence of active material(s) above or below said element (14), said first plate (6A, 46; 44) including at least one inactive region (6B, 55 to 58; 47 to 50) for said sensor (10), said first and second plates being formed at least partially of active material(s) for said sensor (10), said sensor (10) being arranged relative to said first wheel (6; 4) so that its detection element (14) is at least in part above or below said first inactive region (6B, 55 to 58; 47 to 50) in at least one determined angular position of said first wheel (6; 4).

2. Device according to claim 1, **characterised in that** said sensor (10) responds to a variation in the presence of an active material above or below said detection element (14) by a variation in at least one parameter or in a variable of said sensor (10) on which a measurement signal provided thereby depends, said first inactive region (6B, 55 to 58; 47 to 50) having dimensions provided so that said detection element (14) is at least mostly facing said first inactive region (6B, 55 to 58; 47 to 50) in said determined angular position.

3. Device according to claim 1 or 2, **characterised in that** said first inactive region is defined by a first opening (6B, 55 to 58; 47 to 50) provided in said first plate (6A, 46; 44).

4. Device according to claim 3, **characterised in that** said first and second plates are formed by active materials for said sensor (10), the second plate (4A, 44; 46; 70) having at least one second opening (4B, 47 to 50; 55 to 58; 72, 74), said detection element (14) being arranged so that it is at least partially above or below said second opening in at least one determined angular position of said second wheel (4; 6; 68).

5. Device according to claim 4, **characterised in that** said first (30; 60A) and respectively second (38; 54A) semi-axis is defined by a radius starting from said geometrical axis of rotation (8) and either passing substantially through the geometrical centre of said first (6B), respectively second (4B) opening, or defined by a radial edge (86, 88) of said first, respectively second opening (83), or identical to a median line of a portion made of active material of said first (46), respectively second (44) plate extending radially between two inactive regions of said first, respectively second plate.

6. Device according to any of the preceding claims, **characterised in that** said sensor (10) includes a support (12) at the surface of which is arranged said detection element (14), said support (12) being arranged facing said first plate (6A, 46), said second plate (4A; 44) being situated on the other side of said first plate relative to said support (12), said sensor (10) being arranged to detect the presence above said detection element (14) of the active material at least partially forming said second plate (4A; 44) when said first wheel (6) is in said determined angular position.

7. Device according to any of claims 1 to 5, **characterised in that** said sensor (10) includes a support (12) at the surface of which is arranged said detection element (14), said support (12) being arranged between said first and second plates (44, 46; 46, 70), said detection element being situated facing said first plate (44; 46).

8. Device according to claim 7, **characterised in that** it further includes a third wheel (4) which is coaxial to said first and second wheels (6; 68) and including a third plate (44) perpendicular to said geometrical axis of rotation (8), said third wheel (4) defining a third reference geometrical semi-axis whose angular position can be detected by said inductive or capacitive sensor (10), said third plate (44) being situated on the other side of said first plate (46) relative to said support (12) of said sensor (10), and being at least partially formed of an active material for said sensor (10), the latter being arranged to detect the presence above or below said detection element of active material(s) at least partially forming said third plate (44) when said first wheel (6) is in said determined angular position.

9. Device according to claim 8, **characterised in that** said second plate (70) includes at least one second inactive region (72, 74) for said sensor (10), arranged so that said detection element (14) is at least mostly above or below said second inactive region (72, 74) in at least one determined angular position of said second wheel (68).

10. Device according to claim 8 or 9, **characterised in that** said third plate (44) is formed by an active material and has a third opening (47 to 50), said detection element (14) being arranged so that it is at least partially above or below said third opening (47 to 50) in at least one determined angular position of said third wheel (4), said third semi-axis being defined by a radius starting from said geometrical axis of rotation (8) and either passing substantially through the geometrical centre (8) of said third opening (47 to 50), or defined by a radial edge of said third opening (47 to 50), or identical to a median line of a part made of active material of said third plate extending radially between two inactive regions of said third plate (44).

11. Method for detecting the angular positions of N coaxial wheels, N being greater than 1, by means of a single same inductive or capacitive sensor (10), these N wheels respectively including N plates each having at least one inactive region for said sensor which includes a detection element (14) of active materiaf(s) at least partially forming each of said N plates, this detection element (14) and each of said inactive regions being arranged so that they are superposed with each other in at least one determined angular position of the wheel having said inactive region, said N plates each defining a reference geometrical semi-axis which can be detected by said sensor (10), said method comprising in the following successive steps wherein the N plates are numbered in an ascending order from the plate situated closest to said detection element to the plate the furthest from said detection element :
A) Determining the angular position of said semi-axis of wheel No. 1;
B) Bringing into or leaving said inactive regions of wheel No. 1 in superposition with said detection element, or waiting until this inactive region and detection element (14) are superposed with each other;
C) Performing steps A) and B) successively for wheel Nos. 2 to (N-1), if required;
D) Determining the angular position of said semi-axis of wheel N.

12. Method according to claim 11, further including the following successive steps of :
E) Bringing into or leaving inactive region No. 2 in the event that N=2, respectively the inactive regions of wheels Nos. 2 to N in the event that N is greater than 2 in superposition with said detection element, or waiting until said inactive region, respectively said inactive regions and said detection element are superposed with each other;
F) Checking the angular position of said semi-axis of wheel No. 1, and keeping the angular position resulting from this check in the event that it does not correspond to the angular position measured during step A;
G) Performing in ascending order for each wheel No. 2 to (N-1), if required, a check of the angular position of the semi-axis associated with said wheel after having brought into or left the inactive regions of the other wheels in superposition with said detection element, or having waited for said inactive regions and said detection element to be superposed with each other, and keeping the angular position resulting from this check for each wheel No. 2 to (N-1) in the event that it does not correspond to the angular position measured during step C).

13. Method according to claim 12, further including a final step of:
H) Checking the angular position of the semi-axis associated with wheel No. N after having brought into or left said inactive region in the event that N = 2, respectively the inactive regions Nos. 1 to (N - 1) in the event that N is greater than 2, in superposition with said detection element, or having waited for said inactive region, respectively said inactive regions and said detection element (14) to be superposed with each other, this step being performed preferably if the step(s) for checking the angular position(s), of wheel 1, respectively wheels 1 to (N - 1), have shown at least one erroneous detection during steps A) to C).
